# EUROPEAN PATENT SPECIFICATION

(11) **EP 0 389 762 B1**
(45) Date of publication and mention of the grant of the patent: **09.08.1995**
(21) Application number: 90102489.3
(22) Date of filing: 08.02.1990
(51) Int. Cl.: H01L 27/115, H01G 4/12, G11C 11/22

(54) **Memory semiconductor device employing a ferroelectric substance**
Halbleiterspeicheranordnung mit einem ferroelektrischen Material
Dispositif semi-conducteur de mémoire utilisant un matériau ferro-électrique

(30) Priority: 08.02.1989 JP 28940/89; 08.02.1989 JP 28941/89; 07.03.1989 JP 54222/89; 19.05.1989 JP 125804/89; 19.05.1989 JP 125805/89
(43) Date of publication of application: 03.10.1990
(73) Proprietor: SEIKO EPSON CORPORATION, Shinjuku-ku Tokyo-to (JP)
(72) Inventor: Takenaka, Kazuhiro, c/o Seiko Epson Corporation, Suwa-shi, Nagano-ken (JP)
(74) Representative: Hoffmann, Eckart, Dipl.-Ing.

(56) References cited:
- EP-A- 0 236 696
- EP-A- 0 338 157
- IBM TECHNICAL DISCLOSURE BULLETIN, vol. 17, no. 12, May 1975, pages 3548-3549,Armonk, NY, US; W.R. SMITH: "Threshold switch protected ferroelectric memory"

## Description

The present invention relates to a structure of an electrically rewritable non-volatile memory which employs a ferroelectric substance.

Recently utilized semiconductor non-volatile memories of the prior art are EPROMs (Erasable Programmable Read-Only Memories or ultraviolet ray erasable non-volatile memories) and EEPROMs (Electrically Erasable Programmable Read-Only Memories or electrically rewritable non-volatile memories) which typically involve the use of MIS transistors and take advantage of such a phenomenon that a surface potential of a silicon substrate is modulated by injecting electric charges from the silicon substrate into traps within an insulating gate or into a floating gate.

There are produced, however, defects inherent in these non-volatile memories, wherein a voltage at which the information is rewritten is typically as high as 20V or thereabouts, and a rewrite time is amazingly long (e.g., several tens of milliseconds in the case of the EEPROM). Besides, the number of information rewriting operations is as small as approximately 10⁵ times. The repetitive use presents a good number of problems.

A non-volatile memory, which employs ferroelectric substances capable of electrically inverting the polarization, has a possibility of being ideal, because a write time is in principle the same as a read time, and because the polarization is held even when turning off the power supply. Geometries of the non-volatile memories using the ferroelectric substances have already been exemplified in, e.g., US-A-4,149,302 where a capacitor composed of the ferroelectric substance is integrated on a silicon substrate, and US-A-3,832,700 wherein a ferroelectric substance film is disposed at a gate of a MIS transistor. Still another geometry of the non-volatile memory has recently been proposed in IEDM′ 87 pp. 850-851 wherein films are laminated on a MOS semiconductor device depicted in Fig. 11. Referring to Fig. 11, the numeral 1101 represents a P-type silicon substrate; 1102 a LOCOS oxide film for seperating an element; 1103 an N-type diffused layer serving as a source; and 1104 an N-type diffused layer serving as a drain.

The numerals 1105 indicates a gate electrode, and 1106 denotes an inter-layer insulating film. Designated at 1108 is a ferroelectric substance film sandwiched in between electrodes 1107 and 1109, thus constituting a capacitor. The numeral 1110 stands for a second interlayer insulating film; and 1111 a wiring electrode formed of Al. Based on this structure of laminating the films on the MOS semiconductor device, an element area is not so increased. Manufacturing. however, entails a larger number of steps (to additionally form the upper and lower electrodes, a ferroelectric substance film and a second inter-layer insulating film as compared with an ordinary semiconductor device). Supposing that a ferroelectric substance film exhibiting satisfactory properties can be obtained, there still exists a problem of being costly because of an increment in the number of manufacturing steps.

The document EP-A- 0338 157 (prior art according to Art. 54(3) EPC) discloses a memory cell comprising an MOS transistor and a capacitor element integrated on the same semiconductor substrate. The capacitor element is formed by a ferroelectric layer sandwiched between an upper and a lower electrode. The lower electrode passes through a contact hole formed in an insulating layer on the substrate to contact the source of the transistor, which is a high-concentration diffused region in the substrate. The contact area between the lower electrode and the source is smaller than that between the lower electrode and the ferroelectric layer the latter being, however, equal to that between the ferroelectric layer and the upper electrode.

The document EP-A-0 236 696 discloses a semiconductor memory device having the features of the precharacterizing portion of claim 1. In this prior art plural memory cells each including an MOS transistor and a capacitor are formed on a the substrate. Each memory cell is associated with an additional capacitor element formed by a ferroelectric layer sandwiched between a lower electrode and an upper electrode. The lower electrode is formed by a metal wiring layer which, at a different place, contacts one of the diffused drain and source regions of the MOS transistor through a contact hole formed in an interlayer insulating film.

The document IBM Technical Disclosure Bulletin, vol. 17, no. 12, May 1975, pages 3548-3549 discloses a threshold switch protected ferroelectric memory having a plurality of memory cells each comprising between a lower electrode or word line and an upper electrode or bit line a ferroelectric layer and a threshold switching alloy layer one put on the other. By placing the switching alloy on the ferroelectric layer a capacitive voltage divider is formed which decreases the voltage applied to the ferroelectric layer by disturb voltages at unaddressed bits.

It is primary object of the present invention, which obviates the foregoing problems peculiar to the prior art semiconductor devices, to provide a novel semiconductor device, particularly a non-volatile memory device which can be manufactured at low costs with a reduction in the number of manufacturing steps even by using a ferroelectric substance film. Another object of the invention is to provide a method of manufacturing such device.

This objects are achieved with a semiconductor device, a memory device and methods of manufacturing them, respectively, as claimed.

In this configuration of the semiconductor device of the present invention, the lower electrode is any one of Pt, Mo, Ti, W, Ta and Ni or a metal silicide thereof.

A contact area between the ferroelectric substance film and the lower electrode is smaller than that between the ferroelectric substance film and the upper electrode.

In the thus constructed ferroelectric substance memories, the silicide is any one of metal silicides of Pt, Mo, Ti, W, Ta and Ni.

Other objects and advantages of the present invention will become apparent from the following discussion taken in conjunction with the accompanying drawings, in which:
- Figs. 1, 7 and 9: are sectional views each showing the principal portion of a semiconductor device;
- Figs. 3, 5, 8 and 10: are sectional views of a semiconductor device according to the present invention;

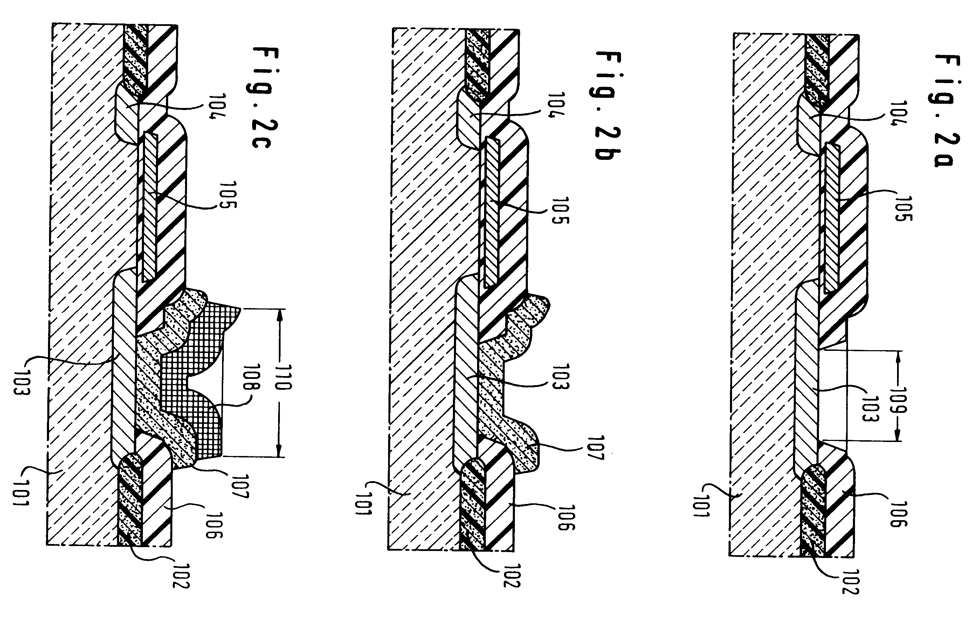

- Figs. 2(a) to 2(c), 4 and 6: are views of assistance in explaining the fundamental steps of manufacturing the semiconductor devices of the invention; and
- Fig. 11: is a sectional view depicting the principal portion of a conventional semiconductor device.

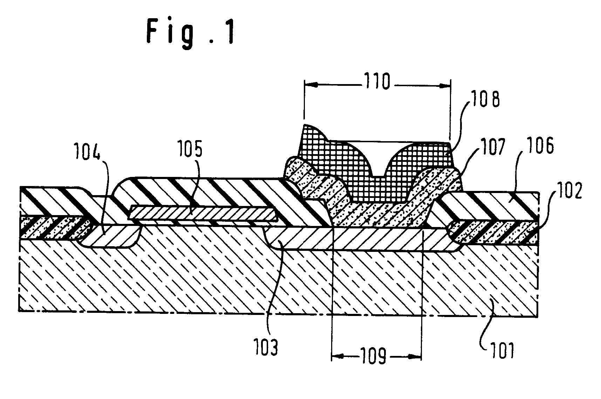

Turning first to Fig. 1, there is illustrated one embodiment of a semiconductor device. For convenience of the explanation, the embodiment will herein deal with a case in which there are employed a silicon substrate and an N-channel transistor.

Designated at 101 is a P-type silicon substrate constructed by using a wafer having a specific resistance of, e.g., 20 Ωcm. An insulating film 102 for seperating an element is obtained by forming an oxide film of 0.6 »m by a conventional technique, i.e., a LOCOS method. Indicated at 103 is an N-type diffused layer serving as a source and formed by effecting phosphorus ion-implantation of 80keV, 5E15cm⁻² for example. An N-type diffused layer 104 serving as a drain is formed concurrently with the diffused layer 103. Formation of a gate electrode 105 involves the use of phosphorus-doped polysilicon. Designated at 106 is an inter-layer insulating film obtained by depositing a phosphorus glass of 0.6 »m on the basis of, e.g., a chemical vapor deposition method. A contact hole 109 formed in the inter-layer insulating film 106 and in other portions (not illustrated) serves to connect the wiring electrode to the diffused layer or the polysilicon. Indicated at 107 is a ferroelectric substance film formed via the contact hole 109 directly on the N-type high-concentration diffused layer 103. A material of the ferroelectric substance film includes, e.g., PbTiO₃, PZT (PbZrO₃ and PbTiO₃) and PLZT (La, PbZrO₃ and PTiO₃). An electrode 108 is made of, for instance, Al and also serves as a wiring electrode in other portions (not shown).

Referring to Fig. 1, a capacitor using the ferroelectric substance film is arranged such that the N-type high-concentration diffused layer 103 is conceived as a lower electrode, while the wiring electrode 108 made of Al is conceived as an upper electrode. Based on this geometry, there is added only a step of forming the ferroelectric substance film 107 as compared with the steps of manufacturing an ordinary MOS semiconductor device. Hence, a semiconductor device employing the ferroelectric substance film can be attained at low costs. The size 110 of the upper electrode of Al is set larger than the contact hole size 109, as a result of which an effective area of the capacitor can be determined by the contact hole size 109. Thus, a capacitor with a small amount of scattering can be constructed.

The description will next be focused on a method of manufacturing the semiconductor device of with reference to Fig. 2. Fig. 2 is a view of assistance in explaining the fundamental steps according to the present invention.

Referring first to Fig. 2(a), on a silicon substrate 101 there are formed an element separating film 102, an N-type diffused layer 104, a gate electrode 105 and an inter-layer insulating film 106. Subsequently, a contact hole 109 is formed therein. This configuration can sufficiently be obtained by conventional techniques. Referring next to Fig. 2(b), thereafter a ferroelectric substance film is shaped by depositing PbTiO₃ up to approximately 0.5 »m on the basis of a sputtering method. Sputtering is effected under such conditions that, for instance: a gas ratio of Ar to oxygen is 90% to 10%; as a target there is employed PbTiO₃ to which Pb of 5-10% is extra added; and RF power is set at 200W. Then, annealing is effected at 600°C for an hour in an N₂ atmosphere, thereby improving crystalline properties of the ferroelectric substance film.

Subsequently, the ferroelectric substance film 107 is formed to a predetermined pattern by a prior art exposing method. Etching of the ferroelectric substance film involves the use of a mixed liquid of, e.g., hydrochloric acid and hydrofluoric acid. Methods of etching the ferroelectric substance film may include ion milling which uses Ar gas or dry etching which employs an adequate reactive gas.

Turning to Fig. 2(c), an upper electrode 108 is formed of Al of 1 »m by sputtering. An electrode pattern is shaped by the conventional exposing technique. An electrode pattern size 110 may be set sufficiently larger than the contact hole size 109.

The semiconductor device is obtained in the manner discussed above. The description given above has dealt with PbTiO₃. However, the present invention can, as a matter of course, be applied to a case where other ferroelectric substance films of, e.g., PZT or PLZT are employed.

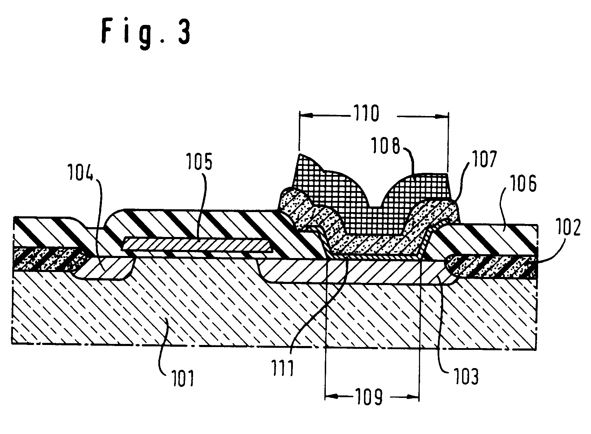

Fig. 3 is a sectional view illustrating the principal portion of an embodiment of the semiconductor device of the invention. The different point from the first embodiment is a lower electrode 111 a material of which includes refractory metals such as Pt, Mo, Ti, W, Ta and Ni and also refractory metal silicides associated with Pt, Mo, Ti, W, Ta and Ni.

Apropos of electric characteristics, the lower electrode according to the present invention can be defined as a metal electrode, which brings about an amelioration of the crystalline properties. This in turn improves, when a Pt metal is used for the electrode, the number of operations of rewriting the information - i.e., from 10⁸ times to 10¹⁰ times - as compared with a case where no metal electrode is proviced. The like effects yielded by using Pt are, though they are more or less different in degree, exhibited in other metals such as Mo, Ti and W and in silicides of these metals as well.

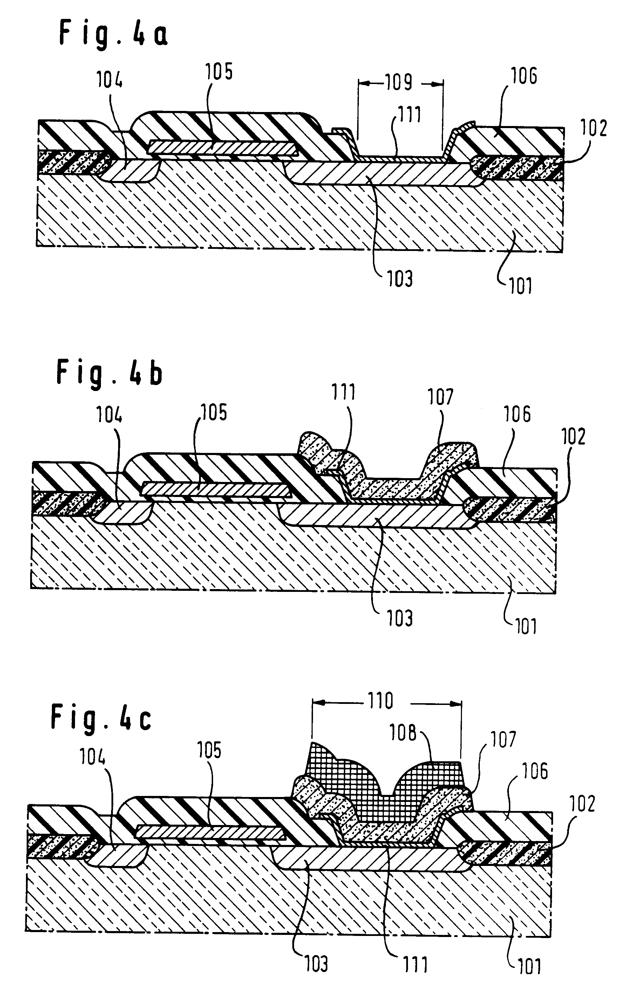

Next, a method of manufacturing the semiconductor device in the second embodiment of the invention will hereinafter be explained in conjunction with Fig. 4 Fig. Fig. 4 is a view of assistance in explaining the fundamental steps according to the present invention.

Formed on a silicon substrate 101 are, as depicted in Fig. 4(a), an element separating film 102, N-type diffused layers 103 and 104, a gate electrode 105 and an interlayer insulating film 106. Subsequently, a contact hole 109 is formed therein. The geometry up to this stage can sufficiently be attained by the conventional techniques. A lower electrode is formed by depositing, e.g., Pt to have a thickness of approximately 0.1 »m by sputtering. Based on a prior art exposing method, a resist pattern is shaped, and the Pt electrode is etched by a sputter-etching method.

Referring to Figs. 4(b) and 4(c), the second embodiment can be completed by performing the same steps as those in the first embodiment.

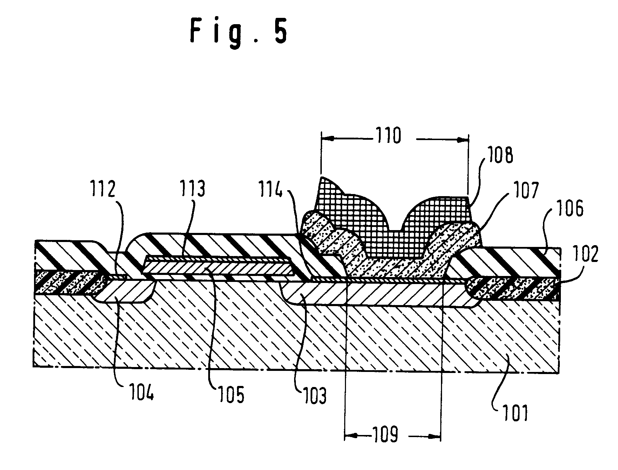

Fig. 5 is a sectional view depicting the principal portion in a third embodiment of the invention. Refractory metal silicides, which will serve as a lower electrode, are formed on a gate, a source and a drain. This is a different geometry from those in the first and second embodiments. Indicated at 112, 113 and 114 are silicides formed on a drain diffused layer 104, a gate electrode 105 and a source diffused layer 103 at the same time. The method of manufacturing those silicide layers (112, 113, 144) will be explained later.

Referring to Fig. 5, a capacitor using the ferroelectric substance film has the lower electrode consisting of silicide 114 composed chiefly of a refractory metal. If, for instance, Pt is employed, it is possible to obtain a ferroelectric substance film exhibiting excellent crystalline properties. Annealing intended to improve the crystalline properties after forming the ferroelectric substance film is allowed to be effected in the vicinity of, e.g., 900°C because of the refractory metal being used. It is therefore feasible to shape a ferroelectric substance film having more excellent crystalline properties.

In connection with the electric characteristics, the lower electrode consists of the refractory metal silicide according to the present invention; and the amelioration of the crystalline properties leads to such an improvement that when the electrode is formed of, for example, a Pt silicide, the information rewriting number increases from 10⁸ times to 10¹⁰ times as compared with a case where no metal electrode is provided. The like effects yielded by employing the Pt silicide can, though they are more or less different in degree, be exhibited in other refractory metals such as Mo, Ti, Pt and W.

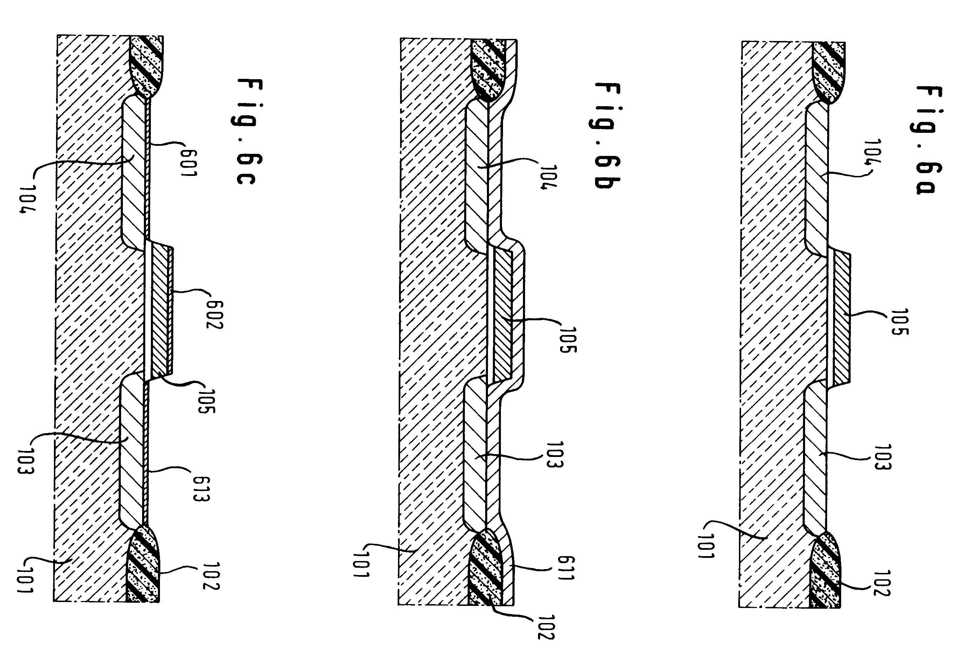

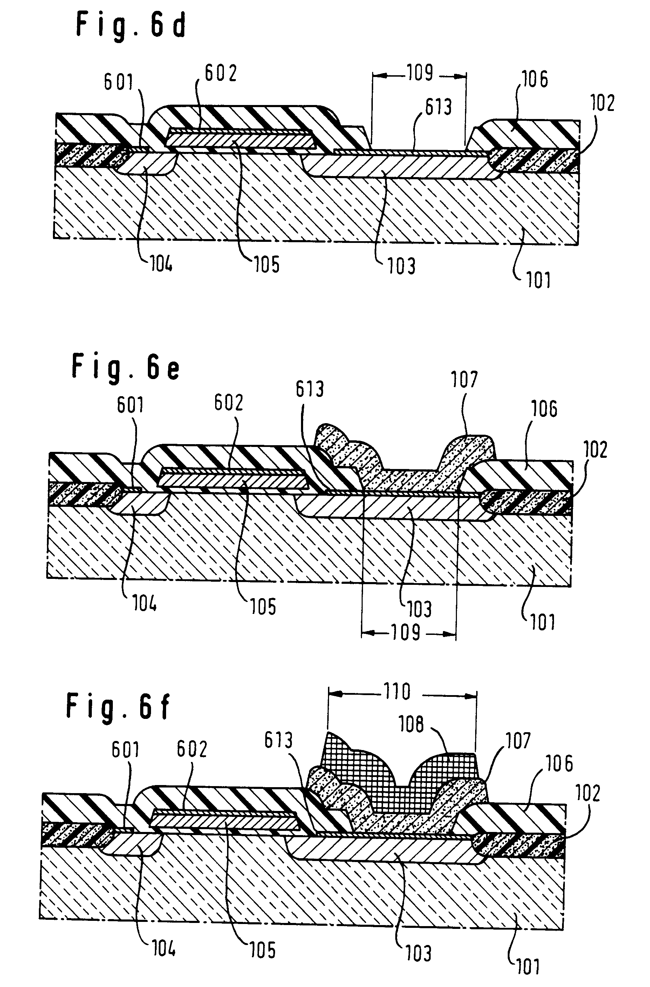

A method of manufacturing the semiconductor device according to the third embodiment of the invention will hereinafter be described with reference to Fig. 6. Fig. 6 is a view of assistance in explaining the fundamental steps according to the present invention.

Formed on a silicon substrate 101, as depicted in Fig. 6(a), are an element separating film 102, N-type diffused layers 103 and 104 and a gate electrode 105. In the wake of this step, as explained earlier, for example, Ti metal 611 is deposited so that the film thickness becomes 0.1 »m (see Fig. 6(b)). Then, annealing is carried out at 800°C for 30 seconds, thereby forming TiSi at the place where Ti contacts Si.

Then only Ti (601, 602, 613) at the place where Ti does not contact Si is etched by wet etching (mixture of NH₄OH, H₂O₂, H₂O). Herein, since the place where TiSi is formed is prevented from being etched, TiSi is retained on the diffused layers 103, 104 and poly Si 105 (see Fig. 6(c)). A refractory metal silicide other than TiSi can be formed in the similar manner as the above.

Then as shown in Figs. 6(d), (e), (f), the layer insulating film (106) is formed, contact hole (109) is formed, and then the upper electrode (108) of ferroelectric film (107) is formed.

The method (d), (e) and (f) is the same as the method of the first embodiment shown in Fig. 1.

There will next be exemplified a case where the present invention is applied to a memory.

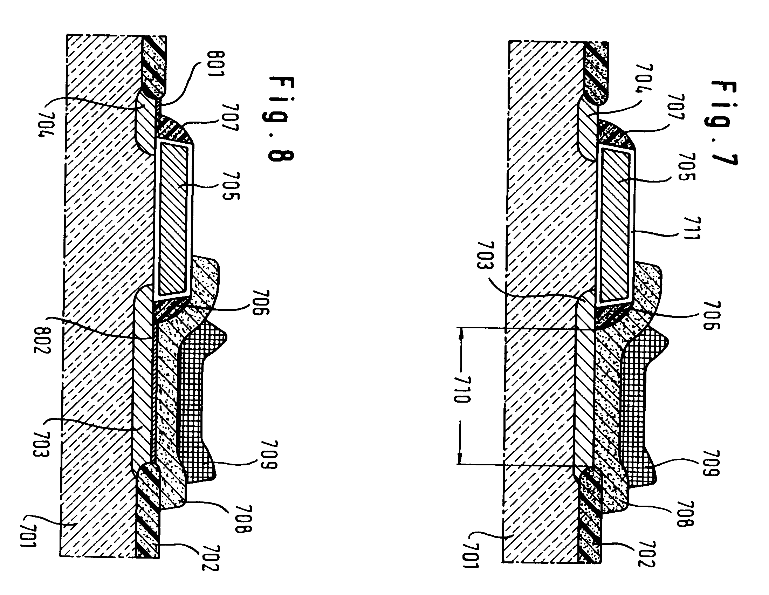

Fig. 7 is a sectional view depicting the principal portion of one embodiment of the semiconductor device. The semiconductor device of the invention will be explained in conjunction with Fig. 7. The description will herein deal with an example where a silicon substrate and an N-channel transistor are employed for convenience of discussion.

Designated at 701 is a P-type silicon substrate which uses a wafer having a specific resistance of, e.g., 20 Ωcm. Indicated at 702 is an insulating film for separating the element, which is obtained by depositing an oxide film up to 0.6 »m on the basis of the prior art LOCOS method. An N-type diffused layer 703 functioning as a source is shaped by effecting, e.g., phosphorus ion-implantation of 80keV, 5E15cm⁻² for example. An N-type diffused layer 704 serving as a drain is formed at the same time with N-type diffused layer 703. Formation of a gate electrode 705 involves the use of, for instance, phosphorus-doped polysilicon. Insulating film 711 is formed so that it covers the polysilicon gate electrode. After formation of the polysilicon gate, wet oxidization (or oxidization in steam) is carried out at 850°C for one hour, for example. As a result, an SiO₂ film having 0.2 »m is formed so that it covers the polysilicon gate. During the oxidization, the oxide film on the Si substrate, where source 703 and drain 704 are formed, grows only to 50 nm. Therefore, the oxide film on the source 703 and drain 704 is removed by a prior art method, such as etching back or wet-etching after oxidization, thereby the oxide film being left only at the peripheral portion of the polysilicon gate. The numerals 706 and 707 represent insulating film side walls shaped on both sides of the gate electrode and defined as one of the components of the present invention. The formation of the side walls is based on the steps of depositing, e.g., a SiO₂ film over the surface to have a thickness of, e.g., 0.6 »m by the chemical vapor deposition method, and thereafter performing etch-back on the entire surface. The method of shaping the side walls is identical with a method of forming a transistor of an LDD (Lightly Doped Drain) structure. Formation of a ferroelectric substance film 708 constituting a ferroelectric substance capacitor requires the steps of depositing, e.g., PZT of 0.5 »m over the surface by sputtering and subsequently effecting a patterning process on a predetermined pattern by dry etching. An upper electrode 709 formed of, e.g., Al is to serve as a wiring electrode of the transistor.

In the embodiment of Fig. 7, the lower electrode is conceived as a high-concentration diffused layer 703 and constructed of the element separating region 702 and the side wall 706 in a self-matching manner, as a result of which the efficiency of a capacitor area 710 becomes large. Besides, the capacitor can be constituted with a small amount of scattering in area. In terms of manufacturing steps, there suffices an addition of only the step of forming the ferroelectric substance film 708 to the prior art steps, thereby attaining the integration with facility.

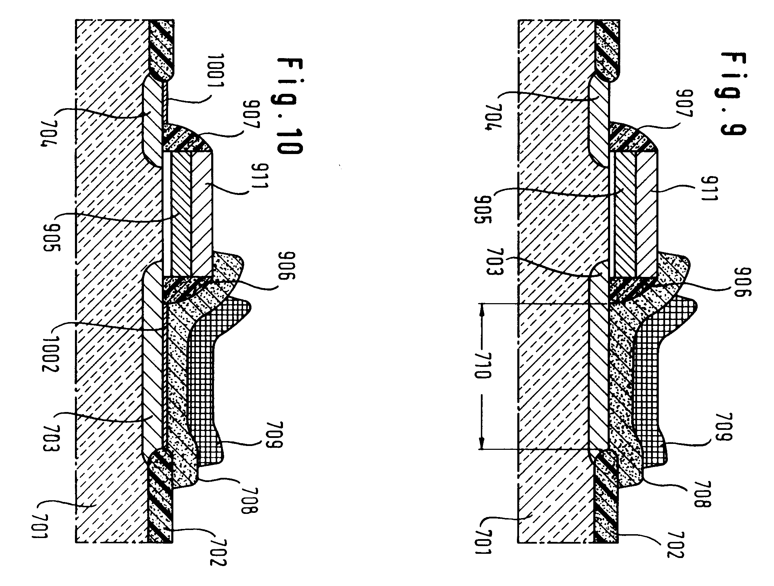

Fig. 8 shows as a modification of the embodiment shown in Fig. 7 an embodiment of the present invention, in which refractory metal silicide 802 is used as the lower electrode of a ferroelectric capacitor. Here, 801 as well as 802 is refractory metal silicide. The method shown in Fig. 6 can be applied to this method, except for that in the embodiment shown in Fig. 8, silicide is not formed on the gate portion since the gate portion is covered with SiO₂. As stated earlier, the silicide serves as the lower electrode, which arrangement makes possible an improvement of crystalline properties of the ferroelectric substance film, because a lattice constant is, when using, e.g., a Pt silicide, relatively approximate in the case of employing, e.g., PZT for the ferroelectric substance film.

A material of the ferroelectric substance film includes, for example, PbTiO₃, PZT and PLZT.

The description given above has dealt with the LOCOS film as an element separating film. The essence of the present invention, however, lies in the arrangement wherein the lower electrode is constructed of the element separating film and the side walls in the self-matching manner. Hence, the present invention can, as a matter of course, be applied to a separating method which uses a trench. It is also obvious that there exists a diversity in geometry, i.e. the invention can be applied to a CMOS structure, a bipolar structure and a bipolar/CMOS structure.

Fig. 9 shows a modified embodiment of the embodiment shown in Fig. 7. In Fig. 7, the oxide film 711 is formed so that it surrounds the whole gate electrode. In the embodiment of Fig. 9 the oxide film 911 is formed only on gate electrode 905 and side-wall insulating films 906 and 907 are formed on the side wall of gate electrode 905 and insulating film 911. This structure brings two advantages: (1) The lower electrode region (710) of the ferroelectric capacitor is determined in a self-aligning manner at the element insulating film 702 and side-wall insulating film 906; and (2) since the insulating film on the gate electrode is formed so that it has a full thickness, the insulation between the gate electrode and another wiring electrode, such as Al (not shown) can be fully kept. The insulating film 911 conceived as one of the components of the invention is formed on the gate electrode to assume the same configuration. A method of shaping the gate electrode 905 and the insulating film 911 comprises the steps of: firstly depositing, e.g., polysilicon, which will become a gate electrode, on the entire surface up to approximately 0.4 »m by a depressurization CVD method; doping the polysilicon by thermal diffusion with the aid of e.g., POCl3, thereafter depositing, for example, SiO₂ of approximately 0.5 »m similarly by the chemical vapor deposition method to thereby obtain the insulating film 911; forming a predetermined resist pattern by the conventional exposing method in this state; and simultaneously etching SiO₂ of the insulating film 911 and polysilicon of the gate electrode 905 by, e.g., dry etching. The geometry depicted in the Figure is thus obtained. Side walls 906 and 907 defined as one of the components of the invention are formed, on both sides of the gate electrode and on side surfaces of the insulating film shaped on this gate electrode. The side walls are shaped in such a way that, for instance, an SiO₂ film having a thickness of 1 jim is formed on the whole surface by, e.g., the vapor growth method, and subsequently the etch-back is effected over the surface. The method of forming these side walls is identical with an approach to formation of a transistor having an LDD structure. Denoted at 708 is the ferroelectric substance film constituting a ferroelectric substance capacitor, which is acquired by depositing, e.g., PZT over the surface to have a thickness of 0.5 »m by sputtering, and subsequently patterning it on a predetermined pattern by dry etching. The upper electrode 709 made of, e.g. Al is to serve as a wiring electrode of the transistor.

In accordance with the embodiment shown in Fig. 9, the high-concentration diffused layer 703 functions as a lower electrode constructed of an element separating region 702 and the side wall 906 in the self-aligning manner. With this arrangement, the efficiency of a capacitor area 710 increases, and it is also possible to constitute the capacitor having a small amount of scattering in area. An insulating film assuming the same configuration as that of the gate electrode is formed thereon, which makes it feasible to manufacture a ferroelectric substance memory having a small quantity of parasitic capacity between the gate electrode and an upper electrode 709 or undergoing no influence of a potential of the gate electrode on the ferroelectric substance film. In terms of the manufacturing steps, an addition of the step of forming the ferroelectric substance film 708 to those in the prior art may suffice, thereby attaining the integration with facility.

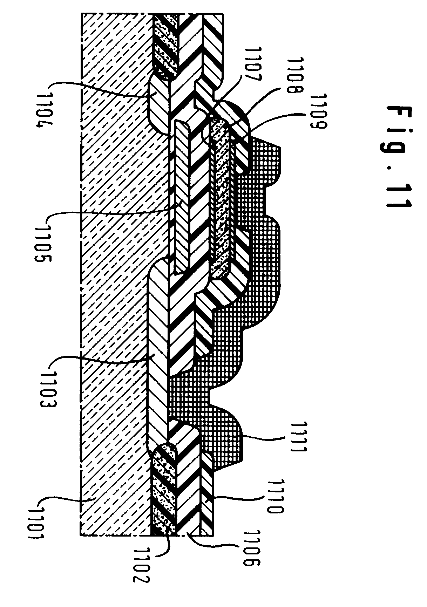

Fig. 10 shows as a modification of the embodiment shown in Fig. 9 an embodiment of the invention, in which refractory metal silicide 1002 is used as the lower electrode of the ferroelectric capacitor. Here, 1001 as well as 1002 is refractory metal silicide. the method shown in Fig. 6 can be applied to this method, except for that in the embodiment shown in Fig. 10, silicide is not formed on the gate portion since the gate portion is covered with SiO₂. As discussed above, the silicide serves as the lower electrode, whereby in the case of using, e.g., a Pt silicide, a lattice constant is, when PZT is used for the ferroelectric substance film,relatively approximate. It is therefore possible to improve the crystalline properties of the ferroelectric substance film.

As materials of the ferroelectric substance film, there will be given, for example, PbTiO₃, PZT and PLZT.

As discussed above, the semiconductor device of the invention as defined in the claims is characterized by the arrangement in which the ferroelectric substance film is formed, via the lower electrode, directly on the diffused layer serving as the source or the drain; the lower electrode for sandwiching the ferroelectric scibstance film in cooperation with another electrode is composed mainly of a metal, and at a contact hole in an insulating layer, the ferroelectric substance film is connected via the foregoing electrode directly to the high-concentration diffused layer formed on the semiconductor substrate; alternatively, a silicide composed chiefly of a refractory metal is formed on the high-concentration diffused layer serving as the source or the drain which is shaped on the semiconductor substrate, and the ferroelectric substance film exhibiting excellent crystalline properties is formed directly on the silicide by performing a small number of steps. Hence, the present invention creates such advantages that it is possible to manufacture the semiconductor device, particularly the non-volatile memory at low costs by a small number of steps and also obtain the ferroelectric substance film having a superb crystalline properties.

## Claims

1. A semiconductor device comprising:
a semiconductor substrate (101, 701),
a high-concentration diffusion layer (103, 703) formed on the substrate and being part of an active semiconductor element such as a MOS transistor,
a ferroelectric substance film (107, 708) sandwiched between an upper and a lower electrode (108, 709, 111, 114, 802, 1002), the lower electrode (111, 114, 802, 1002) being composed mainly of a metal and connected to the diffusion layer (103, 703),
**characterized** in that
the lower electrode (111, 114, 802, 1002) is formed on the diffusion layer (103, 703) at an exposed contact portion thereof, the contact area between the ferroelectric substance film (107, 708) and said lower electrode (111, 114, 802, 1002) being smaller than that between said ferroelectric substance film (107, 708) and the upper electrode (108, 709).

2. The semiconductor device according to claim 1, wherein the material of said lower electrode (111, 114) is any one of Pt, Mo, Ti, W, Ta and Ni.

3. The semiconductor device according to claim 1, wherein the material of said lower electrode (111, 114) is any one of metal silicides of Pt, Mo, Ti, W, Ta and Ni.

4. The semiconductor device according to any one of claims 1 through 3, wherein the ferroelectric substance film (107) contacts the lower electrode (114) through a contact hole (109) formed in an insulating layer (106) which is provided on the lower electrode (114).

5. A memory device comprising:
a capacitor element composed of a ferroelectric substance film (708) sandwiched between an upper and a lower electrode (709, 802), and
an MOS transistor (703, 704, 705) integrated together with the capacitor element on the same semiconductor substrate (701) and having as its source or drain a high-concentration diffusion layer (703) which is formed on the substrate (701) and which is connected to the lower electrode (802) of said capacitor element,
**characterized** in that
the lower electrode (802) of said capacitor element is a silicide made of a refractory metal and is formed on the diffusion layer (703) in a self-aligned manner in an area determined by an element separating region (702) and an insulating material (706) formed on a side wall of a gate electrode (705) of the MOS transistor.

6. The memory device according to claim 5, wherein the lower electrode (1002) is formed on the diffusion layer (703) in a self-aligned manner in an area determined by an element separating region (702) and an insulating material (906) formed on a side wall of the gate electrode (905) and an insulating film (911) formed on the gate electrode and having the same shape as the latter.

7. The memory device according to claim 5 or 6, wherein said silicide is any one of metal silicides of Pt, Mo, Ti, W, Ta and Ni.

8. A method of manufacturing the semiconductor device of claim 1, the method comprising the steps of
(a) forming on a silicon substrate (101) an element separating film (102) such as to expose an element region of the substrate,
(b) forming within said element region source and drain diffused regions (103, 104) and a gate electrode (105) of an MOS transistor,
(c) depositing a refractory metal film (611) on the substrate,
(d) annealing the substrate to form a refractory metal silicide (601, 602, 613) at portions where the refractory metal contacts silicon,
(e) removing the remaining refractory metal by etching,
(f) forming an interlayer insulating film (106) on the substrate,
(g) forming a contact hole (109) in the interlayer insulating film (106) at a position above one (103) of said source and drain diffused regions,
(h) forming a ferroelectric substance film (107) such as to contact the refratory metal silicide portion (613) exposed through the contact hole (109),
(i) patterning the ferroelectric substance film (107) into a predetermined shape, and
(j) forming an upper electrode (108) on the ferroelectric substance film (107).

9. A method of manufacturing the memory device of claim 5, the method comprising the steps of
(a) forming on a silicon substrate (701) an element separating film (702) such as to expose an element region of the substrate,
(b) forming within said element region source and drain diffused regions (703, 704) and a gate electrode (705) of an MOS transistor,
(c) forming an oxide film to cover the gate electrode (705),
(d) forming on the sides of the gate electrode insulating film side walls (706, 707),
(e) depositing a refractory metal film (611) on the substrate,
(f) annealing the substrate to form a refractory metal silicide (601, 602, 613) at portions where the refractory metal contacts silicon,
(g) removing the remaining refractory metal by etching,
(h) forming a ferroelectric substance film (708) such as to contact the refratory metal silicide portion (802) in a self-aligned manner in the area defined between one (706) of said insulating film side walls and the element separating film (702),
(i) patterning the ferroelectric substance film (708) into a predetermined shape, and
(j) forming an upper electrode (709) on the ferroelectric substance film (708).

10. The method of claim 9, wherein step (c) comprises forming the oxide film (911) only on the gate electrode such as to assume the same shape as the gate electrode (905).

## Patentansprüche

1. Halbleitervorrichtung umfassend:
ein Halbleitersubstrat (101, 701),
eine Diffusionsschicht (103, 703) hoher Konzentration, die auf dem Substrat ausgebildet ist und Teil eines aktiven Halbleiterelements wie etwa eines MOS-Transistors ist,
einen Film (107, 708) aus einer ferroelektrischen Substanz, der zwischen einer oberen und einer unteren Elektrode (108, 709, 111, 114, 802, 1002) sandwichartig eingeschlossen ist, wobei sich die untere Elektrode (111, 114, 802, 1002) hauptsächlich aus einem Metall zusammensetzt und mit der Diffusionsschicht (103, 703) verbunden ist,
dadurch gekennzeichnet,
daß die untere Elektrode (111, 114, 802, 1002) auf der Diffusionsschicht (103, 703) an einem freiliegenden Kontaktabschnitt derselben ausgebildet ist, wobei die Kontaktfläche zwischen dem Film (107, 708) der ferroelektrischen Substanz und der unteren Elektrode (111, 114, 802, 1002) kleiner ist als die zwischen dem Film (107, 708) der ferroelektrischen Substanz und der oberen Elektrode (108, 709).

2. Halbleitervorrichtung nach Anspruch 1, bei der das Material der unteren Elektrode (111, 114) irgendeines von Pt, Mo, Ti, W, Ta und Ni ist.

3. Halbleitervorrichtung nach Anspruch 1, bei der das Material der unteren Elektrode (111, 114) irgendeines von Metallsiliziden aus Pt, Mo, Ti, W, Ta und Ni ist.

4. Halbleitervorrichtung nach einem der Ansprüche 1 bis 3, bei der der Film (107) der ferroelektrischen Substanz die untere Elektrode (114) durch ein Kontaktloch (109) kontaktiert, welches in einer Isolierschicht (106) ausgebildet ist, die auf der unteren Elektrode (114) vorgesehen ist.

5. Halbleiterspeicher, umfassend:
ein Kondensatorelement, das sich aus einem Film (708) einer ferroelektrischen Substanz, der zwischen einer oberen und einer unteren Elektrode (709, 802) sandwichartig eingeschlossen ist, zusammensetzt, und
einen MOS-Transistor (703, 704, 705), der zusammen mit dem Kondensatorelement auf demselben Halbleitersubstrat (701) integriert ist und als seine Source oder Drain eine Diffusionsschicht (703) hoher Konzentration aufweist, die auf dem Substrat (701) ausgebildet ist und mit der unteren Elektrode (802) des Kondensatorelements verbunden ist,
dadurch gekennzeichnet, daß
die untere Elektrode (802) des Kondensatorelements ein Silizid aus einem feuerfesten Metall ist und auf der Diffusionsschicht (703) in einer selbstausgerichteten Weise in einer Fläche ausgebildet ist, die von einem Elemententrennbereich (702) und einem Isoliermaterial (706) bestimmt wird, welches an einer Seitenwand einer Gateelektrode (705) des MOS-Transistors ausgebildet ist.

6. Speichervorrichtung nach Anspruch 5, bei der die untere Elektrode (1002) auf der Diffusionsschicht (703) in einer selbstausgerichteten Weise in einer Fläche ausgebildet ist, die von einem Elementtrennbereich (702) und einem Isoliermaterial (706) bestimmt wird, welches an einer Seitenwand der Gateelektrode (905) und eines auf der Gateelektrode ausgebildeten und dieselbe Form wie die letztere aufweisenden Isolierfilms (911) ausgebildet ist.

7. Speichervorrichtung nach Anspruch 5 oder 6, bei der das Silizid irgendeines von Metallsiliziden aus Pt, Mo, Ti, W, Ta und Ni ist.

8. Verfahren der Herstellung der Halbleitervorrichtung von Anspruch 1, wobei das Verfahren die Schritte umfaßt:
(a) Ausbilden auf einem Siliziumsubstrat (101) eines Elementtrennfilms (102) derart, daß ein Elementbereich des Substrats freiliegt,
(b) Ausbilden von Source- und Draindiffusionszonen (103, 104) und einer Gateelektrode (105) eines MOS-Transistors innerhalb des Elementbereichs,
(c) Abscheiden eines feuerfesten Metallfilms (611) auf dem Substrat,
(d) Anlassen des Substrats zur Ausbildung eines feuerfesten Metallsilizids (601, 602, 613) an Stellen, wo das feuerfeste Metall Silizium kontaktiert,
(e) Entfernen des übrigen feuerfesten Metalls durch Ätzen,
(f) Ausbilden eines Zwischenschichtisolierfilms (106) auf dem Substrat,
(g) Ausbilden eines Kontaktloches (109) in dem Zwischenschichtisolierfilm (106) an einer Position über einer (103) der Source- und Draindiffusionszonen,
(h) Ausbilden eines Films (107) aus einer ferroelektrischen Substanz derart, daß er den durch das Kontaktloch (109) freigelegten Abschnitt des feuerfesten Metallsilizids kontaktiert,
(i) Mustern des Films (107) der ferroelektrischen Substanz in eine vorbestimmte Form, und
(j) Ausbilden einer oberen Elektrode (108) auf dem Film (107) der ferroelektrischen Substanz.

9. Verfahren der Herstellung der Speichervorrichtung von Anspruch 5, wobei das Verfahren die Schritte umfaßt:
(a) Ausbilden eines Elementtrennfilms (702) auf einem Siliziumsubstrat (701) derart, daß ein Elementbereich des Substrats freiliegt,
(b) Ausbilden von Source- und Draindiffusionszonen (703, 704) und einer Gateelektrode (705) eines MOS-Transistors innerhalb des Elementbereichs,
(c) Ausbilden eines Oxidfilms zum Bedecken der Gateelektrode (705),
(d) Ausbilden von Isolierfilmseitenwänden (706, 707) auf den Seiten der Gateelektrode,
(e) Abscheiden eines feuerfesten Metallfilms (611) auf dem Substrat,
(f) Anlassen des Substrats zur Ausbildung eines feuerfesten Metallsilizids (601, 602, 613) an Stellen, wo das feuerfeste Metall Silizium kontaktiert,
(g) Entfernen des übrigen feuerfesten Metalls durch Ätzen,
(h) Ausbilden eines Films (708) einer ferroelektrischen Substanz derart, daß sie den Abschnitt (802) des feuerfesten Metallsilizids in dem zwischen einer (706) der Isolierfilmseitenwände und dem Elementtrennfilm (702) gebildeten Bereich in selbstausgerichteter Weise kontaktiert,
(i) Mustern des Films (708) der ferroelektrischen Substanz in eine vorbestimmte Form, und
(j) Ausbilden einer oberen Elektrode (709) auf dem Film (708) der ferroelektrischen Substanz.

10. Verfahren nach Anspruch 9, bei dem Schritt (c) das Ausbilden des Oxidfilms (911) allein auf der Gateelektrode umfaßt, so daß er dieselbe Form wie die Gateelektrode (905) annimmt.

## Revendications

1. Un dispositif à semiconducteurs comprenant :
un substrat semiconducteur (101, 701),
une couche de diffusion à concentration élevée (103, 703), formée sur le substrat et qui fait partie d'un élément à semiconducteurs actif tel qu'un transistor MOS,
une pellicule de matériau ferroélectrique (107, 708) intercalée entre des électrodes supérieure et inférieure (108, 709, 111, 114, 802, 1002), l'électrode inférieure (111, 114, 802, 1002) étant constituée essentiellement par un métal et connectée à la couche de diffusion (103, 703),
caractérisé en ce que
l'électrode inférieure (111, 114, 802, 1002) est formée sur la couche de diffusion (103, 703), dans une partie de contact à nu de cette dernière, l'aire de contact entre la pellicule de matériau ferroélectrique (107, 708) et l'électrode inférieure (111, 114, 802, 1002) étant inférieure à celle qui existe entre la pellicule de substance ferroélectrique (107, 708) et l'électrode supérieure (108, 709).

2. Le dispositif à semiconducteurs selon la revendication 1, dans lequel le matériau de l'électrode inférieure (111, 114) est l'un quelconque des suivants : Pt, Mo, Ti, W, Ta et Ni.

3. Le dispositif à semiconducteurs selon la revendication 1, dans lequel le matériau de l'électrode inférieure (111, 114) est l'un quelconque des siliciures de métal de Pt, Mo, Ti, W, Ta et Ni.

4. Le dispositif à semiconducteurs selon l'une quelconque des revendications 1 à 3, dans lequel la pellicule de matériau ferroélectrique (107) vient en contact avec l'électrode inférieure (114) par un trou de contact (109) formé dans une couche isolante (106) qui est formée sur l'électrode inférieure (114).

5. Un dispositif de mémoire, comprenant :
un élément consistant en un condensateur, formé d'une pellicule de matériau ferroélectrique (708) intercalée entre des électrodes supérieure et inférieure (709, 802), et
un transistor MOS (703, 704, 705) intégré avec l'élément consistant en un condensateur, sur le même substrat semiconducteur (701), et qui comporte, pour sa source ou son drain, une couche de diffusion à concentration élevée (703) qui est formée sur le substrat (701) et qui est connectée à l'électrode inférieure (802) de l'élément consistant en un condensateur,
caractérisé en ce que
l'électrode inférieure (802) de l'élément consistant en un condensateur est un siliciure constitué par un métal réfractaire, et elle est formée d'une manière auto-alignée sur la couche de diffusion (703), dans une zone qui est déterminée par une région de séparation d'élément (702) et un matériau isolant (706) formé sur une paroi latérale d'une électrode de grille (705) du transistor MOS.

6. Le dispositif de mémoire selon la revendication 5, dans lequel l'électrode inférieure (1002) est formée d'une manière auto-alignée sur la couche de diffusion (703), dans une zone qui est déterminée par une région de séparation d'élément (702) et un matériau isolant (906) formé sur une paroi latérale de l'électrode de grille (905), et une pellicule isolante (911) qui est formée sur l'électrode de grille et a la même forme que cette dernière.

7. Le dispositif de mémoire selon la revendication 5 ou 6, dans lequel le siliciure est l'un quelconque des siliciures de métal de Pt, Mo, Ti, W, Ta et Ni.

8. Un procédé de fabrication du dispositif à semiconducteurs de la revendication 1, ce procédé comprenant les étapes suivantes :
(a) on forme sur un substrat en silicium (101) une pellicule de séparation d'élément (102), de façon à laisser à nu une région d'élément du substrat,
(b) on forme à l'intérieur de cette région d'élément, des régions diffusées de source et de drain (103, 104) et une électrode de grille (105) d'un transistor MOS,
(c) on dépose une pellicule de métal réfractaire (611) sur le substrat,
(d) on recuit le substrat pour former un siliciure de métal réfractaire (601, 602, 613) dans des parties dans lesquelles le métal réfractaire est en contact avec le silicium,
(e) on enlève par attaque le métal réfractaire restant,
(f) on forme une pellicule isolante inter-couche (106) sur le substrat,
(g) on forme un trou de contact (109) dans la pellicule isolante inter-couche (106), dans une position située au-dessus de l'une (103) des régions diffusées de source et de drain,
(h) on forme une pellicule de matériau ferroélectrique (107), de façon qu'elle vienne en contact avec la partie de siliciure de métal réfractaire (613) qui est à nu à travers le trou de contact (109),
(i) on définit un motif de forme prédéterminée dans la pellicule de matériau ferroélectrique (107), et
(j) on forme une électrode supérieure (108) sur la pellicule de matériau ferroélectrique (107).

9. Un procédé de fabrication du dispositif de mémoire de la revendication 5, ce procédé comprenant les étapes suivantes :
(a) on forme sur un substrat en silicium (701) une pellicule de séparation d'élément (702), de façon à laisser à nu une région d'élément du substrat,
(b) on forme à l'intérieur de cette région d'élément des régions diffusées de source et de drain (703, 704) et une électrode de grille (705) d'un transistor MOS,
(c) on forme une pellicule d'oxyde de façon à recouvrir l'électrode de grille (705),
(d) on forme sur les côtés de l'électrode de grille des parois latérales (706, 707) constituées par une pellicule isolante,
(e) on dépose une pellicule de métal réfractaire (611) sur le substrat,
(f) on recuit le substrat pour former un siliciure de métal réfractaire (601, 602, 613) dans des parties dans lesquelles le métal réfractaire est en contact avec le silicium,
(g) on enlève par attaque le métal réfractaire restant,
(h) on forme une pellicule de matériau ferroélectrique (708) de façon qu'elle vienne en contact avec la partie de siliciure de métal réfractaire (802), d'une manière auto-alignée, dans une zone qui est définie entre l'une (706) des parois latérales en pellicule isolante et la pellicule de séparation d'élément (702),
(i) on définit un motif de forme prédéterminée dans la pellicule de matériau ferroélectrique (708), et
(j) on forme une électrode supérieure (709) sur la pellicule de matériau ferroélectrique (708).

10. Le procédé de la revendication 9, dans lequel l'étape (c) comprend la formation de la pellicule d'oxyde (911) seulement sur l'électrode de grille, de façon qu'elle prenne la même forme que l'électrode de grille (905).
